(19)

Europäisches
Patentamt
European
Patent Office
Office européen
des brevets

(11) **EP 2 242 110 A1**

(12) **EUROPEAN PATENT APPLICATION**
published in accordance with Art. 153(4) EPC

(43) Date of publication:
**20.10.2010 Bulletin 2010/42**

(51) Int Cl.:
**H01L 31/0236** (2006.01)   **C08J 5/18** (2006.01)

(21) Application number: **09706843.1**

(22) Date of filing: **30.01.2009**

(86) International application number:
**PCT/JP2009/052016**

(87) International publication number:
**WO 2009/096610 (06.08.2009 Gazette 2009/32)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **31.01.2008   JP 2008020449**

(71) Applicant: **Teijin Dupont Films Japan Limited
Chiyoda-ku
Tokyo 100-0013 (JP)**

(72) Inventors:
• **NISHIO, Rei
Anpachi-gun
Gifu 503-0123 (JP)**
• **YOSHIDA, Tetsuo
Anpachi-gun
Gifu 503-0123 (JP)**

(74) Representative: **Cockerton, Bruce Roger
Carpmaels & Ransford
One Southampton Row
London
WC1B 5HA (GB)**

(54) **SOLAR BATTERY BASE**

(57)   It is to provide a base material for a solar cell, constituted, by a stretched film of a composition containing a thermoplastic crystalline resin and inert particles, in which the base material for a solar cell has, on at least one side, a surface that has a center plane average surface roughness Ra of 30 to 500 nm and an average interval between local crests S on the surface of 40 to 5,000 nm, by which the base material for a solar cell provided has a surface capable of providing a light trapping effect and is useful for producing a solar cell exhibiting an excellent photoelectric conversion efficiency upon using as a base material of a thin film solar cell.

Fig. 1

**EP 2 242 110 A1**

**Description**

TECHNICAL FIELD

The present invention relates to a base material for a solar cell used as a base material of a solar cell, and more specifically, relates to a base material for a solar cell that is favorably used as a base material of a flexible type thin film solar cell.

BACKGROUND ART

A solar cell includes a rigid type using glass as a base material and a flexible type using a plastic film. In recent years, a flexible type solar cell is being used frequently as an auxiliary power supply of a mobile communication device, such as a mobile phone and a mobile terminal.

The rigid type has a high conversion efficiency of energy in the solar cell as compared to the flexible type, but is limited in reduction of thickness and weight of the solar cell module, and involves the possibility that the glass as the base material is broken upon receiving impact, thereby braking the solar cell module.

On the other hand, the flexible type has received attention since it can be relatively easily reduced in thickness and weight and has high resistance to impact. For example, JP-A-1-198081 discloses a thin film solar cell having such a structure that an amorphous silicon layer is held with electrode layers on a polymer film as a base material. Additionally, JP-A-2-260557, JP-B-6-5782 and JP-A-6-350117 each disclose a solar cell module using a flexible base plate.

In the thin film solar cell using amorphous silicon, it is important to increase the light absorption amount within the thickness of the light absorbing layer, for enhancing the photoelectric conversion efficiency of the solar cell. Accordingly, such a measure has been employed that an electroconductive layer having unevenness on the surface thereof is formed on a base material to diffuse light, thereby increasing the light path length of the light in the light absorbing layer.

However, the base material is exposed to a temperature of 350°C or more upon forming the electroconductive layer having unevenness on the surface thereof as a metal or metallic oxide layer. A plastic film cannot withstand the temperature and cannot be applied to the measure.

Such a method has been proposed that a solution of a composition containing a resin and a filler added thereto is flow-cast and cured on a base material to provide a sheet with unevenness on the surface thereof, on which an electroconductive layer is then formed (JP-A-1-119074). In this method, however, it is necessary to increase the concentration of the filler in the solution for forming sufficient unevenness, but the sheet becomes brittle when the concentration of the filler is increased and thus cannot be used practically.

Such a method has been proposed that a solution of a resin is coated on a base material to form a film, on which a solution of a resin containing particles is coated to form a film (JP-A-4-1.96364), and such a method has also been disclosed that an ultraviolet ray-curable resin is coated on a base material and then cured with a mold pressed thereon to form unevenness, on which an electroconductive layer is formed (Japanese Patent No. 3,749,015).

However, these methods require a separate process step performed after producing the film, which becomes a factor of increase of the cost. In these methods, furthermore, a solution of a resin composition is coated on a base material for imparting unevenness, but a solvent of the solution remains in the unevenness layer and is evaporated as a gas (degasification) upon forming a transparent electroconductive layer to impair the maintenance of the shape of the unevenness layer, and is also mixed as an impurity into the semiconductor and the transparent electroconductive layer to deteriorate the quality of the product.

JP-B-7-50794 discloses a technique of making unevenness on a surface by utilizing degasification, but it is difficult to control accurately the amount of the solvent remaining in the resin and the degasification amount, and thus it is quite difficult to control the unevenness shape of the surface.

DISCLOSURE OF THE INVENTION

PROBLEMS TO BE SOLVED BY THE INVENTION

An object of the invention is to solve the problems associated with the conventional art and to provide a base material for a solar cell that has a surface capable of providing a light trapping effect and is useful for producing a solar cell exhibiting an excellent photoelectric conversion efficiency upon using as a base material of a thin film solar cell.

MEANS FOR SOLVING THE PROBLEMS

Accordingly, the invention relates to a base material for a solar cell, constituted by a stretched film of a composition containing a thermoplastic crystalline resin and inert particles by melt extrusion, in which the base material for a solar cell has, on at least one side, a surface that has a center plane average surface roughness Ra of 30 to 500 nm and an average interval between local crests S on the surface of 40 to 5,000 nm.

BEST MODE FOR CARRYING OUT THE INVENTION

The invention will be described in detail bellow.
The invention will be described in detail below.

Thermoplastic Crystalline Resin

The thermoplastic crystalline resin in the base material for a solar cell of the invention is a thermoplastic crystalline resin capable of being melt-extruded, and examples thereof include polyether ether ketone, polyphenylene sulfide, polyamide, polyethylene terephthalate and polyethylene 2,6-naphthalate. Among these, polyethylene 2,6-naphthalate, which can be biaxially stretched, has a high mechanical strength and has heat resistance, is particularly preferred.

Inert Particles

The inert particles in the invention are used for forming suitable unevenness on the surface of the film, thereby providing a light trapping effect. The average particle diameter of the inert particles is preferably from 0.05 to 10 $\mu$m, more preferably from 0.1 to 8 $\mu$m, and particularly preferably from 0.2 to 6 $\mu$m. When the average particle diameter of the inert particles is less than 0.05 $\mu$m, a surface shape capable of scattering light sufficiently cannot be formed, whereas when it exceeds 10 $\mu$m, protrusions formed on the surface become too large, and a homogeneous electroconductive layer is difficult to be formed thereon, and thus both cases are not preferred.
The content of the inert particles is preferably from 0.5 to 20% by volume, more preferably from 1 to 15% by volume, and particularly preferably from 2 to 10% by volume, based on 100% by volume of the resin composition constituting the film. The percentage by volume herein is obtained by calculation from the percentage by weight with the true density of the inert particles and the density of the resin in an amorphous state. With the inert particles contained in that range, a surface having unevenness capable of scattering light sufficiently can be formed, and the practical mechanical strength can be maintained.
As the inert particles, inert particles having heat resistance that is sufficient to withstand melt extrusion are used, and examples thereof include inorganic particles, such as spherical silica, porous silica, calcium carbonate, alumina, titanium dioxide, kaolin clay, barium sulfate and zeolite; crosslinked polymer particles, such as silicone resin particles and crosslinked polystyrene particles; and organic salt particles.
The average particle diameter of the inert particles is obtained in such a manner that the particles are measured with Centrifugal Particle Size Analyzer, Model CP-50, produced by Shimadzu Corporation, and a particle diameter corresponding to 50% by weight is read from the accumulated curve of the particles of the respective particle diameters and the existing amounts of the particles calculated based on the resulting centrifugal precipitation curve (see "Ryudo Sokutei Gijutsu" (Particle Size Measurement Techniques), pp. 242-247, published by Nikkan Kogyo Shimbun, Ltd. (1975)).
The inert particles may be of a single kind or may be a combination of plural kinds, and the particles having different average particle diameters may be used in combination.

Stretched Film

In the invention, the composition of the thermoplastic crystalline resin and the inert particles is formed into an unstretched film by melt extrusion, and a film obtained by stretching the unstretched film is used as a base material for a solar cell. The stretched film is preferably a biaxially stretched film from the standpoint of maintenance of the mechanical strength.
In the case where a film is produced, for example, by a solution method but is not produced by melt extrusion and stretching, degasification derived from the remaining solvent occurs in the process of providing an electroconductive layer on the film for fabricating a solar cell, whereby the uneven structure formed on the film before the process of providing the electroconductive layer is disturbed, and thus the uneven structure cannot be accurately reflected to the solar cell.

Additive

The composition constituting the film may contain an additive. Examples of the additive include an antioxidant, a heat stabilizer, a lubricating agent (such as wax), a flame retardant, an antistatic agent and an ultraviolet ray absorbent.

Among these, an ultraviolet ray absorbent is preferably contained for enhancing the weather resistance of the film. The ultraviolet ray absorbent is preferably one having a large absorption coefficient, which exhibits advantages with a small amount, and preferred examples thereof include 2,2'-p-phenylenebis(3,1-benzoxazin-4-one), 2,2'-(4,4'-diphenylene)bis(3,1-benzoxazin-4-one) and 2,2'-(2,6-naphthylene)bis(3,1-benzoxazin-4-one).

The film of the base material for a solar cell of the invention may be a multilayer film. In the case where an ultraviolet ray absorbent is contained in the multilayer film, it may be added to the outermost layer of on the light incident side of the film, thereby enhancing the weather resistance efficiently.

Center Plane Surface Average Surface Roughness Ra

It is important that the base material for a solar cell of the invention has, on at least one side, a surface that has a center plane average surface roughness Ra of 30 to 500 nm and an average interval between local crests S on the surface of 40 to 5,000 nm.

In the invention, the center plane average surface roughness Ra is from 30 to 500 nm, preferably from 35 to 300 nm, and more preferably from 40 to 200 nm. When Ra is less than 30 nm, the scattering effect of light is reduced to provide less effect of enhancing the photoelectric conversion efficiency of the solar cell. When it exceeds 500 nm, on the other hand, protrusions formed on the surface become too large, and a homogeneous electroconductive layer is difficult to be formed thereon.

The center plane average surface roughness Ra can be achieved by controlling the average particle diameter and the mixed amount of the inert particles contained in the composition along with the thermoplastic crystalline resin as described later.

Average Interval Between Local Crests S

In the invention, the average interval between local crests S is from 40 to 5,000 nm, preferably from 50 to 1,000 nm, and more preferably from 60 to 500 nm. When the average interval between local crests S is less than 40 nm, the unevenness contains steep slopes, whereby upon accumulating layers on the film, an accumulated structure that sufficiently reflects the unevenness cannot be formed on the unevenness, and consequently, problems including short circuit occur. When the average interval between local crests S exceeds 5,000 nm, on the other hand, light is not sufficiently scattered due to the small frequency of the unevenness, thereby failing to exhibit the target light trapping effect.

The average interval between local crests S can be obtained in such a manner that the surface roughness curved surface is cut out to the base length L in the average plane direction, the average line lengths Si corresponding to each pair of the adjacent local crests in the base length L are obtained, and the average value S (unit: nm) of the average line lengths Si is calculated by the following expression.

$$ S = \frac{1}{n} \sum_{i=1}^{n} Si $$

The base material for a solar cell of the invention is a film produced with the composition of the thermoplastic crystalline resin containing the inert particles, and the aforementioned values of the center plane average surface roughness Ra and the average interval between local crests S can be achieved by controlling the average particle diameter and the mixed amount of the inert particles.

For example, in the case where the inert particles having an average particle diameter of 0.1 $\mu$m are used, the values can be achieved by adding the inert particles to the composition of the thermoplastic crystalline resin in an amount of 1 to 40% by volume based on 100% by volume of the composition of the thermoplastic crystalline resin. Furthermore, for example, the values can be achieved by adding the inert particles to the composition of the thermoplastic crystalline resin in an amount of 1 to 25% by volume when the inert particles having an average particle diameter of 0.3 $\mu$m are used, can be achieved by adding the inert particles to the composition of the thermoplastic crystalline resin in an amount of 0.3 to 2.5% by volume when the inert particles having an average particle diameter of 1.0 $\mu$m are used, and can be achieved by adding the inert particles to the composition of the thermoplastic crystalline resin in an amount of 0.1 to 3.0% by volume when the inert particles having an average particle diameter of 3.0 $\mu$m are used.

In the invention, the film may be produced by a stretching method, particularly by a biaxial stretching method, thereby providing a film having unevenness defined by the center plane average surface roughness Ra and the average interval between local crests S of the invention. Even though the inert particles are buried in the interior of the film before stretching, the thermoplastic crystalline resin surrounding the inert particles is stretched by stretching, and the inert particles inside the film are pushed out to the surface, thereby providing a favorable texture.

In the invention, a thermoplastic crystalline resin is used, and the resin is crystallized after stretching to fix the structure of the resin. Accordingly, a stable surface uneven structure that is not impaired in a high temperature process can be formed.

In the invention, the surface roughness can be delicately controlled by changing the thickness of the layer containing the inert particles. For example, in the case where it is difficult to achieve the target center plane average surface roughness Ra with the inert particles having a small particle diameter, the thickness of the layer containing the inert particles may be decreased to reflect the shape of the inert particles to the surface shape, thereby providing the sufficient unevenness. For example, in the case where the inert particles having an average particle diameter of 0.1 $\mu$m are used, the thickness of the layer containing the inert particles is preferably from 0.1 to 3 $\mu$m.

In the case where the average particle diameter of the inert particles is large, there are cases where the center plane average surface roughness Ra becomes too large when the content of the inert particles per volume is increased for decreasing the average interval between local crests S. In such cases, the thickness of the layer containing the inert particles is increased, whereby a film having a small average interval between local crests S can be obtained without increasing the center plane average surface roughness Ra by the push-out effect toward the outside of the inert particles contained in the interior of the film.

Furthermore, for example, in the case where the inert particles having an average particle diameter of 1.0 $\mu$m are used, the thickness of the layer containing the inert particles may be 5 $\mu$m or more, thereby providing a film having a small average interval between local crests S.

Other Properties

The base material for a solar cell of the invention preferably has a total light transmittance of 80% or more, whereby the base material can be used as a base material on the front surface electrode side of a super straight solar cell. Even when the total light transmittance is less than 80%, it can be used as a base material for a solar cell, and particularly can be used as a base material on the back surface electrode side.

The base material for a solar cell of the invention preferably has a thermal shrinkage rate of 1% or less, more preferably 0.8% or less, and particularly preferably 0.6% or less, upon treating at 200°C for 10 minutes, from the standpoint of suppressing the dimensional change in the heating step of the fabricating process of the solar cell.

The thickness of the base material for a solar cell of the invention is preferably from 25 to 250 $\mu$m, more preferably from 50 to 200 $\mu$m, and particularly preferably from 60 to 125 $\mu$m, from the standpoint of ensuring the stiffness as the base material for a solar cell and ensuring the flexibility of the solar cell module.

Production Method of Film

The base material for a solar cell of the invention can be produced by melting the composition of the thermoplastic crystalline resin containing the inert particles, melt-extruding the composition to form an unstretched sheet, and stretching the unstretched sheet. The base material is preferably produced by a biaxial stretching method for providing a practical mechanical strength of the film and for forming unevenness sufficiently on the surface of the film by the protrusion effect of the inert particles contained in the thermoplastic crystalline resin. The base material is preferably produced through a crystallization process of the thermoplastic crystalline resin for maintaining the unevenness on the surface in the high temperature process of the fabricating process of the solar cell.

The production method of the film will be described in detail herein with reference, for example, to a method for producing the film by melt extrusion and then sequential biaxial stretching. The melting point is referred to as Tm, and the glass transition temperature is referred to as Tg.

A prescribed amount of the inert particles are added to the thermoplastic crystalline resin, and the inert particles are dispersed in the thermoplastic crystalline resin to form a composition, from which water content is removed depending on necessity by drying through ordinary heating or under reduced pressure. The composition is melted at an ordinary melt extrusion temperature, i.e., a temperature equal to or higher than Tm and equal to or lower than (Tm + 50°C), extruded from a slit of a die, and solidified by quenching on a rotating cooling drum cooled to a temperature equal to or lower than Tg of the thermoplastic crystalline resin, thereby providing an amorphous unstretched sheet. The resulting unstretched sheet is stretched in the machine direction in a stretching ratio of 2.5 to 4.5 times at a temperature equal to or higher than Tg and equal to or lower than (Tg + 50°C) and subsequently stretched in the transversal direction in a stretching ratio of 2.5 to 4.5 times at a temperature equal to or higher than Tg and equal to or lower than (Tg + 50°C). A simultaneous biaxial stretching method, in which stretching steps in the machine direction and the transversal direction are performed simultaneously, may be preferably employed since the mechanical properties between the machine and transversal directions can be well balanced.

The film having, on at least one side, the surface having the center plane average surface roughness Ra and the average interval between local crests S according to the invention can be obtained through the stretching step.

The unevenness on the surface can be controlled by the stretching conditions.

For example, in the case where the inert particles that are not deformed by an external force are used, protrusions are formed on the surface of the film in the stretching step of the film, in which a surface having a larger center plane average surface roughness Ra is obtained when the internal stress generated by stretching is larger, i.e., the film is stretched at a lower temperature in a higher ratio.

For example, in the case where the film is constituted by multiple layers and is stretched with an extremely thin layer as the surface layer containing the inert particles, a surface having unevenness with a high protrusion frequency, which sufficiently reflects the average particle diameter and the added amount of the inert particles, i.e., a surface having a small average interval between local crests S, can be obtained.

The film stretched in the machine and transversal directions is thermally fixed at a temperature equal to or higher than the crystallization temperature of the thermoplastic crystalline resin and equal to or lower than (Tm - 20°C). Thereafter, the film is preferably subjected to a thermal relaxing process with a relaxing ratio of 0.5 to 15% in the machine direction and/or the transversal direction for lowering the thermal shrinkage ratio. The thermal relaxing process may be performed upon producing the film, or may be performed by a separate heat treatment after winding up the film. In the case where a heat treatment is performed after winding up the film, for example, a method of subjecting a film in a hung state to a thermal relaxing process, as disclosed in JP-A-1-275031, may be employed.

When the film is heat-treated at the crystallization temperature of the thermoplastic crystalline resin of the film, a film capable of maintaining the unevenness on the surface even at a high temperature can be obtained.

EXAMPLE

The invention will be described in detail with reference to example below. The measurements and evaluations were performed in the following manners.

The invention will be described in detail with reference to examples below.

The characteristic values were measured in the following manners.

(1) Intrinsic Viscosity

It was obtained by measuring a viscosity of a solution with o-chlorophenol as a solvent at 35°C.

(2) Thickness of Layers

A film specimen was cut out into a triangular shape, and after fixing to an embedding capsule, it was embedded in an epoxy resin. The embedded specimen was cut along the cross section in parallel to the machine direction into a thin film section having a thickness of 50 nm with a microtome (ULTRACUT-S), which was then observed and pictured with a transmission electron microscope (S-4700, produced by Hitachi) at an acceleration voltage of 100 kV with S-4700, produced by Hitachi, thereby measuring the thickness of layers from pictures.

(3) Thermal Shrinkage Rate

The film under no tension was retained in an oven set at a temperature of 200°C for 10 minutes. The length between references points before the heat treatment $L_0$ and the length between reference points after the heat treatment L were measured, and the dimensional change ratio was calculated as a thermal shrinkage rate (%) by the following expression.

$$\text{thermal shrinkage rate (\%)} = ((L_0 - L)/L_0) \times 100$$

(4) Average Particle Diameter of Particles

The particles were measured with Centrifugal Particle Size Analyzer, Model CP-50, produced by Shimadzu Corporation, and a particle diameter corresponding to 50% by weight was read from the accumulated curve of the particles of the respective particle diameters and the existing amounts of the particles calculated based on the resulting centrifugal precipitation curve (see "Ryudo Sokutei Gijutsu" (Particle Size Measurement Techniques), pp. 242-247, published by Nikkan Kogyo Shimbun, Ltd. (1975)).

(5) Center Plane Average Surface Roughness (Ra)

The center plane average surface roughness Ra was obtained by measuring with a non-contact three-dimensional surface structure analyzing microscope (NewView 5022), produced by Zygo Corporation, under conditions of a measurement magnification of 25 times and a measurement area of 283 $\mu$m $\times$ 213 $\mu$m (= 0.0603 mm$^2$), and calculating according to the following expression by the surface analysis software installed in the microscope.

$$Ra = \sum_{k=1}^{M} \sum_{j=1}^{N} |Z_{jk} - \bar{Z}| / (M \cdot N)$$

wherein

$$\bar{Z} = \sum_{k=1}^{M} \sum_{j=1}^{N} Z_{jk} / (M \cdot N)$$

Herein, $Z_{jk}$ represents the height in the two-dimensional roughness chart at the j-th and k-th position in each of the measured direction (283 $\mu$m) and the direction perpendicular thereto (213 $\mu$m), respectively, upon dividing into M segments and N segments in each of the directions, respectively.

(6) Average Interval between Local Crests (S)

The average interval between local crests S was obtained by measuring with a non-contact three-dimensional surface structure analyzing microscope (NewView 5022), produced by Zygo Corporation, under conditions of a measurement magnification of 25 times and a measurement area of 283 $\mu$m $\times$ 213 $\mu$m (= 0.0603 mm$^2$). The roughness curved surface of the surface of the film was cut out to the base length L (283 $\mu$m) in the average plane direction, the average line lengths Si corresponding to each pair of the adjacent local crests in the base length L were obtained, and the average value S (unit: nm) of the average line lengths Si was calculated by the following expression, which was designated as the average interval between local crests S. The calculation was performed by the surface analysis software installed in the microscope with the following expression.

$$S = \frac{1}{n} \sum_{i=1}^{n} Si$$

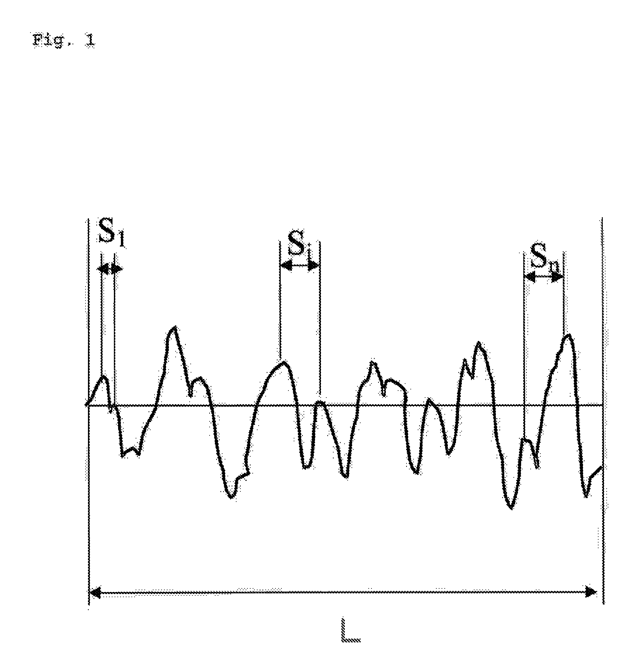

The relationship between the base length L and the average line lengths Si in the measurement of the average interval between local crests S is shown in Fig. 1.

(7) Total Light Transmittance of Film

The total light transmittance Tt (%) was measured according to JIS K6714-1958

(8) Photoelectric Conversion Efficiency of Thin-film Solar Cell

An Ag thin film having a thickness of 200 nm was formed on a surface of a film specimen by a sputtering method, and an AZO thin film having a thickness of 50 nm was further formed thereon. Thereafter, the film specimen having these thin films formed was placed in a plasma CVD apparatus, and a photoelectric conversion layer containing three layers including n-, i- and p-type amorphous silicon (a-Si) layers (total thickness of three layers: 0.4 $\mu$m) was formed at a substrate temperature of 190°C. Thereafter, an AZO thin film having a thickness of 100 nm was formed with a grid pattern mask placed thereon by a sputtering method at a temperature of 190°C, and then an Ag thin film having a thickness of 200 nm was formed with a comb pattern mask by a sputtering method, thereby providing a thin film solar cell.

A solar light stimulation correction filter (AM 1. 5 Global, produced by Oriel) was attached to a 500 W xenon lamp (produced by Ushio, Inc.), and simulated solar light having an incident light intensity of 100 mW/cm$^2$ was radiated onto the thin film solar cell in the direction perpendicular to the horizontal plane. The system was left at rest indoors in an atmosphere at an ambient temperature of 25°C and a humidity of 50%. A DC voltage to be applied to the system was scanned at a constant rate of 10 mV/sec by using a current-voltage measuring device (Source Measure Unit Model 238, produced by Keithley Instruments, Inc.), thereby measuring the I-V curve characteristics. The photoelectric conversion efficiency η (%) was calculated from the short circuit current (Jsc) and the open circuit voltage (Voc) and the FF (fill factor) obtained from the results, according to the following expression.

$$\eta\ (\%)\ =\ \mathtt{Jsc}\ \times\ \mathtt{Voc}\ \times\ \mathtt{FF}$$

In the measurement, the operation factor (%) was calculated from the ratio A/B, in which A represents the number of cells that generated electric power without short circuit and leakage of current, and B represents the total number of the cells produced.

$$\mathtt{operation\ factor}\ (\%)\ =\ \mathtt{A/B}\ \times\ 100$$

Example 1

A composition containing 1.6% by volume of bulk silica having an average particle diameter of 3.8 μm (true density: 2.2) and 98.4% by volume of polyethylene 2,6-naphthalate (amorphous density: 1.33, intrinsic viscosity: 0.65) was dried at 170°C for 6 hours. The composition was then fed to an extruder and extruded at a melt temperature of 305°C from a slit die, followed by being solidified by quenching on a rotating cooling drum having a surface temperature maintained at 50°C, thereby providing an unstretched film. Subsequently, the unstretched film was stretched in the machine direction 3.1 times at 140°C and then stretched in the transversal direction 3.3 times at 145°C, and was subjected to a thermal fixing treatment at 245°C for 5 seconds and shrunk in the transversal direction by 2%, thereby providing a biaxially stretched film having a thickness of 75 μm. The resulting film had a center plane average surface roughness Ra of 173 nm and an average interval between local crests S of 4,832 nm, and the thermal shrinkage rate at 200°C of the film was 0.2%.

A thin film solar cell was produced by using the resulting biaxially stretched film as a base maternal and measured for photoelectric conversion efficiency η (%). As a result, the open circuit voltage was 0.50 V, the short circuit current density was 22.3 mA/cm$^2$, and the photoelectric conversion efficiency η was 5.5%.

Example 2

A composition containing 2.5% by volume of rutile titanium dioxide having an average particle diameter of 0.3 μm (true density: 4.2) and 97.5% by volume of polyethylene 2,6-naphthalate (amorphous density: 1.33, intrinsic viscosity: 0.63) was dried at 170°C for 6 hours. The composition was then fed to an extruder and extruded at a melt temperature of 305°C from a slit die, followed by being solidified by quenching on a rotating cooling drum having a surface temperature maintained at 50°C, thereby providing an unstretched film. Subsequently, the unstretched film was stretched in the machine direction 3.1 times at 140°C and then stretched in the transversal direction 3.3 times at 145°C, and was subjected to a thermal fixing treatment at 245°C for 5 seconds and shrunk in the transversal direction by 2%, thereby providing a biaxially stretched film having a thickness of 75 μm. The resulting film had a center plane average surface roughness Ra of 43 nm and an average interval between local crests S of 3,740 nm, and the thermal shrinkage rate at 200°C of the film was 0.3%.

A thin film solar cell was produced by using the resulting biaxially stretched film as a base material and measured for photoelectric conversion efficiency η (%). As a result, the open circuit voltage was 0.52 V, the short circuit current density was 23.8 mA/cm$^2$, and the photoelectric conversion efficiency η was 6.2%.

Example 3

A composition containing 2.5% by volume of rutile titanium dioxide having an average particle diameter of 0.3 $\mu$m (true density: 4.2) and 97.5% by volume of polyethylene 2,6-naphthalate (amorphous density: 1.33, intrinsic viscosity: 0.63) and polyethylene naphthalate containing no inert particle each were dried at 170°C for 6 hours. They each were fed to a co-extruder and extruded at a melt temperature of 305°C from a slit die, followed by being solidified by quenching on a rotating cooling drum having a surface temperature maintained at 50°C, thereby providing an unstretched accumulated film. Subsequently, the unstretched accumulated film was stretched in the machine direction 3.1 times at 140°C and then stretched in the transversal direction 3.3 times at 1.45°C, and was subjected to a thermal fixing treatment at 245°C for 5 seconds and shrunk in the transversal direction by 2%, thereby providing a biaxially stretched accumulated film having a total thickness of 75 $\mu$m containing an inert particle-containing layer having a thickness of 1 $\mu$m. The rougher surface of the resulting biaxially stretched accumulated film had a center plane average surface roughness Ra of 33 nm and an average interval between local crests S of 2,586 nm, and the thermal shrinkage rate at 200°C of the film was 0.3%.

A thin film solar cell was produced by using the resulting biaxially stretched accumulated film as a base material and measured for photoelectric conversion efficiency $\eta$ (%). As a result, the open circuit voltage was 0.53 V, the short circuit current density was 24.2 mA/cm$^2$, and the photoelectric conversion efficiency $\eta$ was 6.4%.

Example 4

A composition containing 6.0% by volume of rutile titanium dioxide having an average particle diameter of 0.3 $\mu$m (true density: 4.2) and 94% by volume of polyethylene 2,6-naphthalate (amorphous density: 1.33, intrinsic viscosity: 0.63) and polyethylene 2,6-naphthalate containing no inert particle each were dried at 170°C for 6 hours. They each were fed to a co-extruder and extruded at a melt temperature of 305°C from a slit die, followed by being solidified by quenching on a rotating cooling drum having a surface temperature maintained at 50°C, thereby providing an unstretched accumulated film. Subsequently, the unstretched accumulated film was stretched in the machine direction 3.1 times at 140°C and then stretched in the transversal direction 3.3 times at 145°C, and was subjected to a thermal fixing treatment at 245°C for 5 seconds and shrunk in the transversal direction by 2%, thereby providing a biaxially stretched accumulated film having a total thickness of 75 $\mu$m containing an inert particle-containing layer having a thickness of 1 $\mu$m. The rougher surface of the resulting biaxially stretched accumulated film had a center plane average surface roughness Ra of 56 nm and an average interval between local crests S of 1,834 nm, and the thermal shrinkage rate at 200°C of the film was 0.2%.

A thin film solar cell was produced by using the resulting biaxially stretched accumulated film as a base material and measured for photoelectric conversion efficiency $\eta$ (%). As a result, the open circuit voltage was 0.53 V, the short circuit current density was 25.0 mA/cm$^2$, and the photoelectric conversion efficiency $\eta$ was 6.6%.

Example 5

A composition containing 2.5% by volume of rutile titanium dioxide having an average particle diameter of 0.3 $\mu$m (true density: 4.2) and 97.5% by volume of polyethylene terephthalate (amorphous density: 1.34, intrinsic viscosity: 0.60) and polyethylene 2,6-naphthalate containing no inert particle each were dried at 170°C for 6 hours. They each were fed to a co-extruder and extruded at a melt temperature of 305°C from a slit die, followed by being solidified by quenching on a rotating cooling drum having a surface temperature maintained at 50°C, thereby providing an unstretched accumulated film. Subsequently, the unstretched accumulated film was stretched in the machine direction 3.1 times at 140°C and then stretched in the transversal direction 3.3 times at 145°C, and was subjected to a thermal fixing treatment at 245°C for 5 seconds and shrunk in the transversal direction by 2%, thereby providing a biaxially stretched accumulated film having a total thickness of 75 $\mu$m containing an inert particle-containing layer having a thickness of 1 $\mu$m. The rougher surface of the resulting biaxially stretched accumulated film had a center plane average surface roughness Ra of 31 nm and an average interval between local crests S of 2,320 nm, and the thermal shrinkage rate at 200°C of the film was 0.5%.

A thin film solar cell was produced by using the resulting biaxially stretched accumulated film as a base material and measured for photoelectric conversion efficiency $\eta$ (%). As a result, the open circuit voltage was 0.50 V, the short circuit current density was 20.2 mA/cm$^2$, and the photoelectric conversion efficiency $\eta$ was 5.2%.

Comparative Example 1

A composition containing 0.3% by volume of spherical silica having an average particle diameter of 1 $\mu$m (true density: 2.2) and 99.7% by volume of polyethylene 2,6-naphthalate (amorphous density: 1.33, intrinsic viscosity: 0.65) was dried at 170°C for 6 hours. The composition was then fed to an extruder and extruded at a melt temperature of 305°C from a slit die, followed by being solidified by quenching on a rotating cooling drum having a surface temperature maintained at 50°C, thereby providing an unstretched film. Subsequently, the unstretched film was stretched in the machine direction 3.1 times at 140°C and then stretched in the transversal direction 3.3 times at 145°C, and was subjected to a thermal fixing treatment at 245°C for 5 seconds and shrunk in the transversal direction by 2%, thereby providing a biaxially stretched film having a thickness of 75 $\mu$m. The resulting biaxially stretched film had a center plane average surface roughness Ra of 26 nm, and the thermal shrinkage rate at 200°C of the film was 0.4%.

A thin film solar cell was produced by using the resulting biaxially stretched film as a base material and measured for photoelectric conversion efficiency $\eta$ (%). As a result, the open circuit voltage was 0.42 V, the short circuit current density was 18.7 mA/cm$^2$, and the phpotoelectric conversion efficiency $\eta$ was 4.7%.

## ADVANTAGES OF THE INVENTION

According to the invention, such a base material for a solar cell can be provided that has a surface capable of providing a light trapping effect and is useful for producing a solar cell exhibiting an excellent photoelectric conversion efficiency upon using as a base material of a thin film solar cell.

## BRIEF DESCRTPTION OFP THE DRAWING

Fig. 1 shows the relationship between the base length L and the average line lengths si upon calculation of the average internal between local crests (s).

## INDUSTRIAL APPLICABILITY

The base material for a solar cell of the: invention can be favorably used as a base material for a flexible type thin film solar cell.

## Claims

1.  A base material for a solar cell, comprising a stretched film of a composition containing a thermoplastic crystalline resin and inert particles by melt extrusion, the base material for a solar cell having, on at least one side, a surface that has a center plane average surface roughness Ra of 30 to 500 nm and an average interval between local crests S on the surface of 40 to 5,000 nm.

2.  The base material for a solar cell according to claim 1, which is used as a base material for a flexible rype thin film solar cell.

Fig. 1

| **INTERNATIONAL SEARCH REPORT** | International application No. |
|---|---|
| | PCT/JP2009/052016 |

**A. CLASSIFICATION OF SUBJECT MATTER**
*H01L31/0236*(2006.01)i, *C08J5/18*(2006.01)i

According to International Patent Classification (IPC) or to both national classification and IPC

**B. FIELDS SEARCHED**

Minimum documentation searched (classification system followed by classification symbols)
H01L31/00-31/20, C08J5/00-5/24

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2004-179441 A (Kyocera Corp.), 24 June, 2004 (24.06.04), (Family: none) | 1-2 |
| Y | JP 2003-110125 A (Mitsubishi Heavy Industries, Ltd.), 11 April, 2003 (11.04.03), (Family: none) | 1-2 |
| Y | WO 96/06128 A1 (Asahi Chemical Industry Co., Ltd.), 29 February, 1996 (29.02.96), & EP 778308 A1 & US 5853907 A & JP 2001-114913 A & DE 69527148 T | 1-2 |

| ☒ Further documents are listed in the continuation of Box C. | ☐ See patent family annex. |
|---|---|

| \* | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 01 April, 2009 (01.04.09) | 14 April, 2009 (14.04.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| | International application No. |
|---|---|
| | PCT/JP2009/052016 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2007-59534 A  (Toyobo Co., Ltd.),<br>08 March, 2007 (08.03.07),<br>(Family: none) | 1-2 |
| Y | JP 2004-140143 A  (National Institute of<br>Advanced Industrial Science and Technology),<br>13 May, 2004 (13.05.04),<br>(Family: none) | 1-2 |
| Y | JP 11-20019 A  (Asahi Chemical Industry Co.,<br>Ltd.),<br>26 January, 1999 (26.01.99),<br>(Family: none) | 1-2 |
| P,Y | JP 2008-41746 A  (Teijin DuPont Films Japan<br>Ltd.),<br>21 February, 2008 (21.02.08),<br>(Family: none) | 1-2 |
| P,Y | JP 2008-41674 A  (Teijin DuPont Films Japan<br>Ltd.),<br>21 February, 2008 (21.02.08),<br>(Family: none) | 1-2 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 1198081 A
- JP 2260557 A
- JP 6005782 B
- JP 6350117 A
- JP 1119074 A
- JP 4196364 A
- JP 3749015 B
- JP 7050794 B
- JP 1275031 A

### Non-patent literature cited in the description

- Ryudo Sokutei Gijutsu. Nikkan Kogyo Shimbun, Ltd, 1975, 242-247